Europäisches Patentamt

(19) European Patent Office

Office européen des brevets

(11) Publication number: **0 183 552 B2**

(12) **NEW EUROPEAN PATENT SPECIFICATION**

(45) Date of publication of the new patent specification : **16.10.91 Bulletin 91/42**

(51) Int. Cl.⁵: **G03F 7/027, C08F 279/02**

(21) Application number : **85308674.2**

(22) Date of filing : **28.11.85**

(54) **A photopolymerizable composition.**

The file contains technical information submitted after the application was filed and not included in this specification

(30) Priority : **28.11.84 JP 249624/84**

(43) Date of publication of application : **04.06.86 Bulletin 86/23**

(45) Publication of the grant of the patent : **16.03.88 Bulletin 88/11**

(45) Mention of the opposition decision : **16.10.91 Bulletin 91/42**

(84) Designated Contracting States : **BE DE FR GB IT**

(56) References cited :
**DE-A- 2 062 563**
**DE-A- 2 939 989**
**US-A- 4 177 074**
**US-A- 4 275 142**

(73) Proprietor : **Asahi Kasei Kogyo Kabushiki Kaisha**
**2-6, Dojimahama 1-chome Kita-ku**
**Osaka-shi Osaka 530 (JP)**

(72) Inventor : **Nakamura, Shohei**
**3675-16, Imaizumi, Fuji-shi**
**Shizuoka-ken (JP)**
Inventor : **Takahashi, Katsuhiro**
**Asahi Kasei Shuuhou-ryo, 61-3, Nakamaru**
**Fuji-shi Shizuoka-ken (JP)**

(74) Representative : **Woodcraft, David Charles et al**
**BROOKES & MARTIN High Holborn House**
**52/54 High Holborn**
**London, WC1V 6SE (GB)**

EP 0 183 552 B2

Jouve, 18, rue Saint-Denis, 75001 PARIS

## Description

This invention relates to a novel photopolymerizable composition. More particularly, the present invention is concerned with a photopolymerizable composition which can be developed with an aqueous developer and which is useful especially for the manufacture of flexographic printing plates.

Recently, the printing plates prepared from a photopolymerizable elastomeric composition have some to be utilized for flexographic printing in place of the rubber plates for flexographic printing. Examples of such photopolymerizable elastomeric composition are found in Japanese Patent Application Publication Nos. 51—4337/1976, 56—29260/1981 and 53—37764/1978, Japanese Patent Application Laid-Open Specification No. 55 48744/1980 and French Patent No. 2103825. All of these compositions comprise as the major component a diene polymer such as a polystyrene-polyisoprene-polystyrene block copolymer, polystyrene-polybutadiene-polystyrene block copolymer or acrylonitrile-butadiene rubber. Also in DE—A—2 062 563 there is disclosed a photopolymerizable composition comprising a copolymer of acrylonitrile and butadiene containing carboxyl groups, a saturated halogenated polymer, a bismaleimide compound and a photoinitiator. In preparing printing plates from such compositions, the development after exposure is conducted using an organic solvent. The use of an organic solvent is generally hazardous to human health and brings about environmental pollution problems. Further, some kinds of organic solvents may be the cause of a fire. Consequently, the working atmosphere is bad or a huge investment should be made in manufacturing facilities to avoid such problems. Due to the pollution control regulations which become severe year after year, utilization of the above-mentioned compositions is becoming difficult for preparing flexographic printing plates.

In order to obviate such problems, studies have been made on the photopolymerizable compositions which can be developed with an aqueous developer, and several proposals have been made as a result of such studies.

For example, it was proposed in U.S. Patent No. 4,275,142 (U.K. Patent No. 1,547,536 corresponding thereto) to use a photopolymerizable composition comprising (1) a copolymer having a molecular weight of 5,000 to 100,000 and prepared by solution radical copolymerizing (A) 10 to 95 mol% of a conjugated diene type hydrocarbon such as butadiene, isoprene, chloroprene, dimethylbutadiene and the like, (B) 5 to 90 mol% of an $\alpha,\beta$-ethylenically unsaturated carboxylic acid or anhydride and (C) 0 to 85 mol% of a monoolefinically unsaturated compound and (2) a photosensitizer, and optionally (3) a photopolymerizable unsaturated monomer such as styrene, $\alpha$-methylstyrene and the like. As another proposal, there may be mentioned the use of a photopolymerizable elastomeric composition comprising (a) 55 to 85 percent by weight, based on the total weight of the composition, of a high molecular weight copolymer of butadiene and acrylonitrile having a number average molecular weight of 20,000 to 75,000, an acrylonitrile group content of 10 to 50 percent by weight and a carboxyl group content of 1 to 15 percent by weight; (b) 5 to 40 percent by weight, based on the total weight of the composition, of a low molecular weight polybutadiene having a number average molecular weight of 750 to 10,000, an acrylonitrile group content of 0 to 50 percent by weight and a carboxyl group content of 0 to 15 percent by weight, provided that the high molecular weight copolymer (a) and the low molecular weight polybutadiene (b) in combination contains at least 2 percent by weight, based on the total weight of the polymers (a) and (b), of a carboxyl group; (c) 2 to 40 percent by weight, based on the total weight of the composition, of a nongaseous, ethylenically unsaturated compound containing at least one terminal ethylenic group, said unsaturated compound being capable of forming a high polymer by free-radical initiated, chain-propagating addition polymerization and being compatible with both the above-mentioned polymers (a) and (b); and (d) 0.001 to 10 percent by weight, based on the total weight of the composition, of an organic free radical-forming agent activatable by actinic rays which initiate polymerization of unsaturated compounds. This photopolymerizable elastomeric composition is disclosed in U.S. Patent No. 4,177,074.

The gist of these proposals resides in the introduction of a polar group, such as carboxyl group, alkali metal salts of carboxyl group, alkaline earth metal salts of carboxyl group and ammonium salts of carboxyl group, into the skeleton polymer to obtain a photopolymerizable composition which can be developed using an aqueous alkaline solution or a mixture of an aqueous alkaline solution and an organic solvent and which is useful for producing a printing plate having a rubber elasticity. In reality, however, the printing plates prepared from these photopolymerizable compositions are poor in physical properties such as mechanical strength and elongation. Hence, such compositions cannot be employed for actual use in the industry. According to the study on flexographic printing plates made by the present inventors, it has been found that in order that a printing plate has desirable handling characteristics and printing durability thereby to render it useful for actual utilization in the industry, the printing plate must exhibit a value of 20,000 or more as a product of breaking strength (Kg/cm$^2$) and elongation at break (%) as measured according to Japanese Industrial Standard K6301. However, the printing plates prepared from the above-mentioned conventional photopolymerizable compositions exhibit only 10,000 or less as the value of a product as defined above.

2

With a view to providing a photopolymerizable composition which can be developed with an aqueous developer to prepare a desirable flexographic printing plate and which is free from the above-mentioned problems, the inventors have made extensive and intensive study. As a result, it has unexpectedly been found that the later-defined photopolymerizable composition can be developed with an aqueous developer and is useful especially for the manufacture of flexographic printing plates, and that the flexographic printing plates prepared from the later-defined composition have such a property that the value of the above-mentioned product or breaking strength and elongation at break is more than 20,000. Based on these novel findings, the present invention has been completed.

The present invention therefore aims to improve on known photopolymerizable compositions comprising a copolymer including a plurality of non-terminal ethylenic groups, a monomeric cross linking agent, and a photoinitiator and thereby provide a novel photopolymerizable composition which can be developed, after exposure to actinic rays, with an aqueous developer to manufacture a flexographic printing plate improved in handling characteristics and printing durability.

The foregoing and other features and advantages of the present invention will be apparent to those skilled in the art from the following detailed description and appended claims.

In the present invention, the photopolymerizable composition is characterised by comprising:

(a) 80 to 99.49 percent by weight, based on the components (a), (b) and (c), of a copolymer having a number average molecular weight of 20,000 to 70,000, said copolymer being one wihich is obtained by copolymerizing:

(i) 50 to 95 percent by weight, based on the components (i), (ii) and (iii), of at least one conjugated diene compound.

(ii) 5 to 40 percent by weight, based on the components (i), (ii) and (iii), of at least one $\alpha,\beta$-ethylenically unsaturated carboxylic acid, and

(iii) 0 to 30 percent by weight, based on the components (i), (ii) and (iii), of at least one monoene compound selected from the group consisting of styrene, $\alpha$-methyl styrene, vinyl-toluene, p-methoxystyrene, acrylonitrile, methacrylonitrile, vinyl chloride, vinylidene chloride acrylamide, methocrylamide and vinylacetate;

(b) 05 to 15 percent by weight, based on the components (a), (b) and (c), of at least one N-substituted maleimide compound or a mixture of at least one N-substituted maleimide compound and at least one ethylenically unsaturated compound; and

(c) 0.01 to 5 percent by weight, based on the components (a), (b) and (c), of a photopolymerization initiator.

As specific examples of the conjugated diene compound for forming the component (i) of the copolymer to be used in the present invention, there may be mentioned butadiene, isoprene, chloroprene, dimethylbutadiene and the like. Of them, butadiene and isoprene are preferred from the viewpoint of availability. The amount of the conjugated diene compound in the copolymer is in the range of 50 to 95 percent by weight based or the components (i), (ii) and (iii). When the amount of the conjugated diene compound is less than about 50 percent by weight based on the components (i), (ii) and (iii), the ultimate printing plate is rigid and brittle and shows poor rubber elasticity. On the other hand, when the amount of the conjugated diene compound is more than about 95 percent by weight based on the components (i), (ii) and (iii), the development of the resulting photopolymerizable composition, after exposure, with an aqueous developer becomes difficult.

As specifc examples of the $\alpha,\beta$-ethylenically unsaturated carboxylic acid for forming the component (ii) of the copolymer to be used in the present invention, there may be mentioned monocarboxylic acids such as acrylic acid, methacrylic acid and the like; dicarboxylic acids such as fumaric acid, maleic acid, itaconic acid and the like; and monoesters and acid anhydrides of the above-mentioned dicarboxylic acids. When a member selected from dicarboxylic acids and monoesters and acid anhydrides thereof is used as the $\alpha,\beta$-ethylenically unsaturated carboxylic acid, developability of the resulting photopolymerizable composition with an aqueous developer can be improved but gelation may occur during the copolymerization with other components. Therefore, monocarboxylic acids such as acrylic acid and methacrylic acid are prefarably used.

The amount of the $\alpha,\beta$-ethylenically unsaturated compound in the copolymer is preferably in the range of about 5 to 40 percent by weight based on the components (i), (ii) and (iii).

When the amount of the $\alpha,\beta$-ethylenically unsaturated compound is less than 5 percent by weight, development of the resulting photopolymerizable composition, after exposure, with an aqueous developer becomes difficult. On the other hand, when the amount of the $\alpha,\beta$-ethylenically unsaturated compound is more than 40 percent by weight, the resulting photopolymerizable composition gives a photocured element which greatly swells at the time of development with an aqueous developer, so that the fine structure of relief on the element is unfavorably distorted.

The monoene compound for forming the component (iii) of the copolymer to be used in the present invention styrene, $\alpha$-methylstyrene, vinyltoluene, p-methoxystyrene, acrylonitrile, methacrylonitrile, vinyl chloride, vinyl-

3

idene chloride, acrylamide, methacrylamide or vinyl acetate.

The monoene compound may be used alone or in mixture in an amount of from about 0 to 30 percent by weight, based on the components (i), (ii) and (iii). The hardness, ink adaptability and the other properties of the ultimate printing plate may be varied according to the kind of the monoene compound. Since styrene is capable of improving transparency of the resulting copolymer, it is preferred that styrene per se or a mixture of styrene and other monoene compound or compounds be used.

The above-described components (i), (ii) and (iii) are subjected to copolymerization reaction to prepare a copolymer to be employed in the present invention. The copolymerization method is not critical. Any known copolymerization methods may be employed. However, generally, the emulsion copolymerization method and solution radical copolymerization method are preferably employed. With respect to the former, reference may be made to, for example, Canadian patent No. 614,181, particularly Example V. With respect to the latter, reference may be made to, for example, U.S. Patent No 4,275,142, particularly column 8, line 15 to column 9, line 28 and Example 1—(1). The copolymer to be employed in the present invention has a number average molecular weight of about 20,000 to 70,000 as measured by the gel permeation chromatography method using polystyrene as the standart material. The molecular weight of the copolymer may be controlled by customary techniques. For example, the control may be effected by varying the quantity of the polymerization initiator and/or the quantity of the chain transfer agent.

As the N-substituted maleimide to be employed in the present invention, there may be mentioned, for example, maleimide compounds having at the N-position thereof a substituent selected from a straight chain alkyl group having 1 to 22 carbon atoms, preferably 6 to 22 carbon atoms, a branched alkyl group having 1 to 22 carbon atoms, preferably 6 to 22 carbon atoms, a cyclic alkyl group having 1 to 22 carbon atoms, preferably 6 to 22 carbon atoms, an unsubstituted phenyl group, an unsubstituted naphthyl group, a phenyl group substituted with a halogen atom or a straight chain or branched alkyl group having 1 to 6 carbon atoms, a naphthyl group substituted with a halogen atom or a straight chain or branched alkyl group having 1 to 6 carbon atoms and the like. Moreover, there may be mentioned N-substituted maleimides having at the N-position thereof an aralkyl group substituent of which the alkyl moiety has 1 to 6 carbon atoms and is substituted with at least one phenyl group; and maleimide compounds having two maleimide groups bonded, at the respective N-positions thereof, to a divalent hydrocarbon residue such as an alkylene group having 1 to 12 carbon atoms, a phenylene group, a biphenylene group, a 1,6-hexamethylenebiphenylene group, a methylenebiphenylene group, a 2,2-diphenylenepropane group or the like. As specific examples of such maleimide compounds, there may be mentioned N-methylmaleimide, N-ethylmaleimide, N-propylmaleimide, N-butylmaleimide, N-pentylmaleimide, N-n-hexylmaleimide, N-cyclohexylmaleimide, N-n-octylmaleimide, N-2-ethylhexylmaleimide, N-n-decylmaleimide, N-laurylmaleimide, N-stearylmaleimide, N-biphenylmaleimide, N-phenylmaleimide, N-chlorophenylmaleimide, N-tolylmaleimide, N-xylylmaleimide, N-benzylmaleimide, N-(6-phenylhexyl)maleimide, methylene, bismaleimide, ethylene bismaleimide, trimethylene bismaleimide, hexamethylene bismaleimide, decamethylene bismaleimide, dodecamethylene bismaleimide, phenylene bismaleimide, 2,2-diphenylenepropane bismaleimide, diphenylenemethane bismaleimide and the like. However, the N-substituted maleimide compounds that may be used in the present invention are not limited to the above-mentioned examples.

Of the above-mentioned N-substituted maleimide compounds, N-alkylmaleimides, N-phenylmaleimide and N-benzylmaleimide are preferred from the viewpoints of availability and cost. Unsubstituted maleimides have a strong irritating odor, and the compability thereof with the other components of the photopolymerizable composition is poor. Therefore, unsubstituted maleimides cannot be employed in the actual manufacturing process of the composition of the present invention. In the case where a thick printing plate, for example one having a thickness of 3 mm or more, is prepared, it is preferred that N-alkylmaleimides be used.

The photopolymerizable composition of the present invention contains the N-substituted maleimide compound in an amount of 0.5 to 15 percent by weight based on the components (a), (b) and (c). When the content of the N-substituted maleimide compound is less than 0.5 percent by weight, the physical properties of the ultimate printing plates cannot be sufficiently improved. On the other hand, when the content of the N-substituted maleimide compound is more than 15 percent by weight, the photopolymerization at the time of exposure to actinic rays proceeds to excess, thereby causing the physical properties of the ultimate printing plates to tend to be poor. In addition, when the photopolymerizable composition contains an N-substituted maleimide compound having a low solubility in the copolymer to be used in the present invention, deposition of the maleimide compoud may occur during the storage of the composition at a low temperature. For this reason, the more preferred content of the N-substituted maleimide compound may be in the range of 0.5 to 10 percent by weight.

The N-substituted maleimide compound that may be used in the present invention can be readily synthesized, for example, from maleic anhydride and a primary amine corresponding to the desired compound in accordance with the method described in "Organic synthesis" published by john Wiley & Sons Inc., New York, Vol. 41, p.93 (1961), etc.

In the photopolymerizable composition of the present invention, an ethylenically unsaturated compound may be used in combination with the N-substituted maleimide compound without adversely affecting the physical properties of the ultimate printing plate and photosensitive characteristics of the composition.

As examples of the ethylenically unsaturated compound which can be used in the present invention, there may be mentioned esters of acrylic acid, methacrylic acid, fumaric acid, maleic acid and the like; derivatives of acrylamide and methacrylamide; allyl esters, styrene and derivatives thereof; and the like. As specific examples of such compounds, there may be mentioned diacrylates and dimethacrylates of ethylene glycol, diethylene glycol, propylene glycol, dipropylene glycol, polyethylene glycol, polypropylene glycol and butylene glycol, trimethylolpropane triacrylate, trimethylolpropane trimethacrylate, pentaerythritol tetraacrylate, pentaerythritol tetramethacrylate, N,N'-hexamethylene bisacrylamide, N,N'-hexamethylene bismethacrylamide, diacetone acrylamide, diacetone methacrylamide, styrene, vinyltoluene, divinylbenzene, diallyl phthalate, triallyl cyanurate, diethyl fumarate, dibutyl fumarate, dioctyl fumarate, distearyl fumarate, butyl octyl fumarate, diphenyl fumarate, dibenzyl fumarate, dibutyl maleate, dioctyl maleate, bis(3-phenylpropyl)fumarate, dilauryl fumarate, di(biphenyl)fumarate and the like. However, the ethylenically unsaturated compounds that may be used in the present invention are not limited to the compounds exemplified above. These compounds may be used alone or in combination.

The amount of the ethylenically unsaturated compound to be contained in the photopolymerizable composition of the present invention may be varied according to the kind of the ethylenically unsaturated compound employed, the desired property of the flexographic printing plate to be prepared, the kind of the copolymer to be used, the kind and amount of the N-substituted maleimide compound to be used and the like. An appropriate amount may be chosen taking the above factors into consideration. It is to be noted, however, that too large an amount of the ethylenically unsaturated compound may cause such problems that the ultimate printing plate becomes rigid and brittle and shows such a poor rubber elasticity that it can no longer be used as a flexographic printing plate. For this reason, it is preferred that the ethylenically unsaturated compound be added in an amount not exceeding 20 percent by weight, preferably 15 percent by weight, based on the total weight of the photopolymerizable composition.

As the photopolymerization initiator that may be used in the present invention, there may be mentioned, for example, benzoin and derivatives thereof such as benzoin methyl ether, benzoin ethyl ether, benzoin isopropyl ether, benzoin isobutyl ether, α-methylolbenzoin, α-methylolbenzoin methyl ether, α-methoxybenzoin methyl ether, benzoin phenyl ether, α-t-butylbenzoin, 2,2-dimethoxy-2-phenyl-acetophenone and 2,2-diethoxyphenylacetophenone, 2,2-diethoxyacetophenone, benzophenone, anthraquinone, benzanthraquinone, 2-ethylanthraquinone, 2-chloroanthraquinone and the like. The photopolymerization initiator may be added in an amount which is effective to initiate polymerization, i.e., at least 0.01 percent by weight, preferably 0.1 to 5 percent by weight.

The photopolymerizable composition of the present invention may further comprise 0.001 to 2 percent by weight, based on the total weight of the photopolymerizable composition, of a heat polymerization inhibitor. As such heat polymerization inhibitors, there may be mentioned, for example, 2,6-di-t-butyl-p-cresol, p-methoxyphenol, pentaerythritol tetrakis[3-(3',5'-di-t-butyl-4'-hydroxy)phenylpropionate], hydroquinone, t-butylcatechol, t-butylhydroxyanisole, 4,4'-butylidenebis(3-methyl-6-t-butyl)phenol and the like.

If desired, the photopolymerizable composition of the present invention may further comprise a plasticizer. In some cases, the plasticizer promotes the removal of a light-unexposed area of the photopolymerizable composition layer, improves the physical properties of the light-exposed area of the photopolymerizable composition layer and facilitates the formation or molding of the photopolymerizable composition. In accordance with the physical properties intended to obtain, the plasticizer may be added in an amount of 2 to 40 percent by weight based on the total weight of the photopolymerizable composition. As such plasticizers, there may be mentioned hydrocarbon oils such as naphthene oil and paraffin oil, low-molecular-weight polystyrene (having a number average molecular weight of 3,000 or less), α-methylstyrene-vinyltoluene copolymers, petroleum resins, pentaerythritol ester of hydrogenated rosin, polyterpene resins, polyester resins, polyethylene, poly(α-methylstyrene), polyacrylates, liquid 1,2-polybutadiene, liquid 1,4-polybutadiene, liquid acrylonitrile/butadiene copolymers, liquid styrene/ butadiene copolymers, mixtures of maleic anhydride and one of the above-mentioned liquid rubbers, stearic acid, polypentadienes, polyurethanes, esters, polyoxyethylenes, polyoxypropylene rubbers and the like.

The photopolymerizable composition of the present invention is sometimes sticky according to the recipe thereof. Therefore, when a printing plate is prepared using the photopolymerizable composition of the present invention, in order to attain good contact between the photopolymerizable composition and an image-bearing transparency to be superimposed thereon and in order to enable the reuse of the image-bearing transparency, a protective film may be disposed on the surface of the photopolymerizable composition layer. The thickness of the protective film may be within the range of 0.05 to 40 μm. The protective film may be composed of a water-insoluble polymer such as polyethylene, polypropylene, polyester and polystyrene, or a polymer soluble or swellable in a developer such as soluble polyamide, monocarboxylic acid ester of cellulose, partially saponified polyvinyl acetate, dicarboxylic acid half ester of cellulose, hydroxypropyl cellulose and polyacrylamide. In the case where the water-insoluble polymer is used, the film is stripped off after the light exposure through the image-bearing transparency disposed on the film has been completed. In the case where the polymer soluble or swellable in a developer is used, the film is removed by dissolution or brushing simultaneously when the light-unexposed area is dissolved away after the light exposure through the image-bearing transparency.

The photopolymerizable composition of the present invention may be shaped into a plate or sheet by employing various methods. For example, the photopolymerizable composition of the present invention is dissolved under agitation in an appropriate solvent such as tetrahydrofuran, toluene, 1,1,1-trichloroethane or perchloroethylene, the resulting solution is cast in a mold, and the solvent is then evaporated. Thus, a plate is simply formed and can be used as such. Further, the so formed plate may be heated under pressure to obtain a plate having a uniform thickness. The heating and pressing may generally be conducted under the following conditions:

| | | |
|---|---|---|
| Temperature: | 120 to 150°C | |
| Time: | preheating (heating without pressing) | 5 to 10 min |
| | pressing | 5 to 10 min |
| | cooling | 5 to 10 min |
| Pressure: | 10 to 100 kg/cm² (980 to 9800 kPa) | |

The heating and pressing conditions may be chosen which are out of the above ranges. However, for example, with respect to the temperature, when the temperature is too low, the flowability of the photopolymerizable composition is poor, leading to a decrease in precision of the thickness of the resulting plate. On the other hand, when the temperature is too high, the photopolymerizable composition suffers unfavorable change in property. Therefore, the heating and pressing conditions should be appropriately chosen according to the property of the copolymer used.

As another method of preparing a plate or sheet, the photopolymerizable composition of the present invention is kneaded using a kneader or a roll mill without the use of a solvent to obtain a homogeneous composition, and the resulting composition is subjected to extrusion, injection, pressing or calendering to form a plate or sheet having a desired thickness, for example 0.7 to 7 mm, generally 1.7 to 4 mm.

In addition to the protective film as described hereinbefore, a support film may be provided. The support film may be disposed on the side of the photopolymerizable composition layer which is remote from that of the protective film. The support film is provided to facilitate the handling of the photopolymerizable composition layer and attain the dimensional stability of the layer. The support film may be composed of, for example, polyethylene terephthalate, polypropylene, polycarbonate, polyvinyl acetate, aluminum, steel or the like.

The protective film and the support film can be attached to the so prepared photopolymerizable composition plate or sheet by roll lamination technique. It is preferred that heat pressing be carried out after the roll lamination to render uniform the thickness of the resulting film-laminate plate or sheet.

To provide a protective film composed of a polymer soluble in a developer as mentioned above on the surface of the photopolymerizable composition layer, a solution of such polymer in an appropriate solvent may be directly applied to the surface of the photosensitive layer, followed by drying. Alternatively, the polymer solution may be first applied to a film of polyester or polypropylene, followed by drying to obtain a polymer-coated film and then the resulting polymer-coated film may be laminated onto the photopolymerizable composition layer.

Of the above-mentioned materials for forming the thin flexible layer, a partially saponified polyvinyl acetate and a dicarboxylic acid half ester of cellulose such as cellulose acetate phthalate are preferred.

The photopolymerizable composition of the present invention is subjected to photopolymerization reaction and development to produce a printing plate. The photopolymerizable reaction and development may be conducted according to customary procedures as disclosed in, for example, U.S. Patents No. 4,197,130, No. 4,266,005 and No. 4,177,074.

As the actinic radiation source that may be used to render developer-insoluble the photopolymerizable composition of the present invention, there may be mentioned a low pressure mercury lamp, a high pressure mercury lamp, an ultraviolet fluorescent lamp, a carbon arc lamp, a xenon lamp, a zirconium lamp, sun light and the like.

An image is formed on the photopolymerizable composition layer by actinic radiation through an image-bearing transparency, and then, the unexposed area is dissolved away by a developer. In this respect, it is necessary that this developer can dissolve and remove the unexposed area without having adverse effect on the exposed image area.

The composition of the developer may be varied mainly depending on the property and amount of the copolymer incorporated in the photopolymerizable composition of the present invention. Generally, as the developer, there may be employed water or an aqueous solution containing, generally in an amount of up to 30% by weight, an alkali such as sodium hydroxide, sodium carbonate, sodium silicate or sodium borate, a surface active agent or a water-soluble organic solvent.

The temperature at which the developer is applied may be about 25°C. In order to effect efficient development, the developer may preferably be used at a temperature of 50° to 70°C.

The development time is so set that a required depth of a relief is obtained.

The photopolymerizable composition of the present invention can be developed with an aqueous developer and can provide a flexographic printing plate having a high mechanical strength and high elongation and hence, having a sufficient printing durability and handling characteristics. Besides, the photopolymerizable composition of the present invention can be used for production of a photoresist or a screen for screen printing.

The present invention will now be described in detail by reference to the following Examples, which should not be construed to limit the scope of the present invention.

Example 1 and Comparative Example 1

There was used a butadiene-methacrylic acid-styrene copolymer (weight ratio: 75/15/10, number average molecular weight: 40,000 (as measured by the gel permeation chromatography method using polystyrenes as the standard materials)] available from Nippon Zeon Co., Ltd., Tokyo, Japan. 100 Parts by weight of the copolymer, 10 parts by weight of N-laurylmaleimide, 2 parts by weight of 2,2-dimethoxy-2-phenylacetophenone and 0.2 part by weight of 2,6-di-t-butyl-p-cresol were kneaded using a kneader at 130°C for 20 minutes, followed by heat pressing at 130°C to obtain a photopolymerizable composition sheet having a thickness of 3 mm and sandwiched between two polyester films. One side of the obtained sheet was exposed to ultraviolet rays having an intensity of 2 mW/cm² and emitted from an ultraviolet fluorescent lamp for 20 minutes and, then, the other side of the sheet was exposed in the same manner for 20 minutes. Two polyester films were stripped off from both sides of the sheet. Then, the breaking strength and elongation at break of the obtained sheet were determined in accordance with Japanese Industrial Standards K6301. As a result, it was found that the breaking strength and elongation at break of the sheet were as high as 128 kg/cm² and 430%, respectively.

For the purpose of comparison, a photopolymerizable composition sheet was prepared in the same manner as described above except that 10 parts by weight of hexanediol dimethacrylate was used instead of 10 parts by weight of N-laurylmaleimide. The breaking strength and elongation at break of the obtained sheet were determined in the same manner as described above and found to be as low as 60 kg/cm² and 140%, respectively.

Example 2

There was used a butadiene-methacrylic acid-acrylonitrile copolymer [weight ratio: 65/8/27, number average molecular weight: 50,000 (as measured by the gel permeation chromatography method using polystyrenes as the standard materials)] available from Nippon Zeon Co., Ltd., Tokyo, Japan. 140 Parts by weight of the copolymer, 40 parts by weight of a liquid butadiene-methacrylic acid-acrylonitrile copolymer (weight ratio: 65/8/27, number average molecular weight: 5,000), 16 parts by weight of hexanediol dimethacrylate, 4 parts by weight of N-laurylmaleimide, 4 parts by weight of 2,2-dimethoxy-2-phenylacetophenone and 0.4 part by weight of 2,6-di-t-butyl-p-cresol were kneaded using a kneader at 130°C for 20 minutes, followed by heat pressing at 130°C to obtain a photopolymerizable composition sheet having a thickness of 3 mm and sandwiched between two polyester films. The obtained sheet was cut into two pieces of sheet. One of the pieces was exposed to actinic radiation in the same manner as described in Example 1 and the breaking strength and elongation at break of the sheet were determined in the same manner as described in Example 1. As a result, it was found that the breaking strength and elongation at break of the sheet were 50 kg/cm² and 600%, respectively. It was also found that the Shore hardness (A) of the sheet was 54° as measured at 20°C. It was confirmed that the obtained sheet is suitable for a flexographic printing plate.

One side of the other piece of cut sheet was exposed to actinic radiation having an intensity of 2.5 mW/cm² and emitted from an ultraviolet fluorescent lamp for 5 minutes. Then, the polyester film of the other side of the sheet was stripped off and an image-bearing transparency was closely contacted with the surface of photopolymerizable composition layer, followed by exposure to actinic radiation having an intensity of 2.5 mW/cm$^2$ and emitted from the same light source through the image-bearing transparency for 30 minutes.

Then, the image-bearing transparency was removed and the unexposed area was dissolved away and removed, using a brush, by an aqueous developer (60°C) containing 0.3 percent by weight of NaOH and 7 percent by weight of butyl carbitol. Thus, there was obtained a relief of 0.7 mm in depth.

Comparative Example 2

Substantially the same procedures as described in Example 2 were repeated to obtain a photopolymerizable composition sheet except that N-laurylmaleimide was not used. In substantially the same manner as in Example 2, the obtained sheet was exposed to actinic radiation and the breaking strength and elongation at break of the resulting sheet were determined. As a result, it was found that the breaking strength and elongation at break of the sheet were as poor as 28 kg/cm$^2$ and 260%, respectively.

Example 3

There was used a butadiene-methacrylic acid copolymer [weight ratio: 85/15, number average molecular weight 38,000 (as measured by the gel permeation chromatography method using polystyrenes as the standard materials)] available from Nippon Zeon Co., Ltd., Tokyo, Japan. 160 Parts by weight of the copolymer, 20 parts by weight of diester prepared from diethylene glycol monobutyl ether and adipic acid, 4 parts by weight of N-cyclohexylmaleimide, 12 parts by weight of dioctyl fumarate, 4 parts by weight of tetraethylene glycol dimethacrylate, 4 parts by weight of 2,2-dimethoxy-2-phenylacetophenone and 0.4 part by weight of 2,6-di-t-butyl-p-cresol were kneaded using a kneader at 130°C for 20 minutes, followed by heat pressing at 130°C to obtain a photopolymerizable composition sheet having a thickness of 3 mm and sandwiched between two polyester films. The obtained sheet was cut into two pieces of sheet. One of them was exposed to actinic radiation in the same manner as in Example 1 and the breaking strength, elongation at break and Shore Hardness (A) of the sheet were determined in the same manner as in Example 1. As a result, it was found that the breaking strength, elongation at break and Shore hardness (A) were 60 kg/cm$^2$, 520% and 59°, respectively. Thus, it was confirmed that the obtained sheet was suitable for flexographic printing plate.

Then, the other piece of sheet was exposed to actinic radiation through an image-bearing transparency in substantially the same manner as in Example 2. Then, the image-bearing transparency was removed and the unexposed area was dissolved away and removed, using a brush, by an aqueous developer (60°C) containing 0.3 percent by weight of NaOH and 7 percent by weight of butyl carbitol. Thus, there was obtained a relief of 1.2 mm in depth.

Referential Example

100 Parts by weight of polystyrene-polyisoprene-polystyrene block copolymer [styrene content: 14 percent by weight, number average molecular weight: 100,000 (as measured by the gel permeation chromatography method using polystyrenes as the standard materials), molecular weight ratio: polystyrene/polyisoprene/polystyrene = 7,000/86,000/7,000], 8 parts by weight of dioctyl fumarate, 2 parts by weight of 2,2-dimethoxy-2-phenylacetophenone and 0.2 part by weight of 2,6-di-t-butyl-p-cresol were kneaded to prepare Photopolymerizable Resin Composition R—1 in the same manner as in Example 1. The obtained composition was subjected to heat pressing to prepare a sheet having a thickness of 3 mm and sandwiched between two polyester films in the same manner as in Example 1. 100 Parts by weight of polystyrene-polyisoprene-polystyrene block copolymer (having the same styrene content and number average molecular weight as mentioned above), 4 parts by weight of dioctyl fumarate, 4 parts by weight of N-lauryl-maleimide, 2 parts by weight of 2,2-dimethoxy-2-phenylacetophenone and 0.2 part by weight of 2,6-di-t-butyl-p-cresol were kneaded to prepare Photopolymerizable Resin Composition R—2 in the same manner as in Example 1. The obtained composition was subjected to heat pressing to prepare a sheet having a thickness of 3 mm and sandwiched between two polyester films in the same manner as in Example 1.

In substantially the same manner as in Example 1, the above-obtained two sheets were exposed to actinic radiation and the breaking strength and elongation at break of the sheets were determined. The results are shown in Table below.

TABLE

| Composition | Maleimide Compounds | Breaking Strength [Kg/cm²] | Elongation at Break [%] |
|---|---|---|---|
| R—1 | None | 50 | 960 |
| R—2 | present | 34 | 430 |

It is understood from the above results that when a thermoplastic elastomeric block copolymer is used, the addition of a maleimide compound causes decrease in breaking strength and elongation at break of the obtained sheet.

**Claims**

1. A photopolymerizable composition comprising a copolymer including a plurality of non-terminal ethylenic groups, a monomeric crosslinking agent, and a photoinitiator, characterized in that it comprises:

a) 80 to 99.49 percent by weight, based on the components (a), (b) and (c), of a copolymer having a number average molecular weight of 20,000 to 70,000: said copolymer being one which is obtained by copolymerizing

i) 50 to 95 percent by weight, based on the components (i), (ii) and (iii), of at least one conjugated diene compound,

ii) 5 to 40 percent by weight, based on the components (i), (ii) and (iii), of at least one $\alpha,\beta$-ethylenically unsaturated carboxylic acid, and

iii) 0 to 30 percent by weight, based on the components (i), (ii) and (iii), of at least one monoene compound selected from the group consisting of styrene, $\alpha$-methylstyrene, vinyl-toluene, p-methoxystyrene, acrylonitrile, methacrylonitrile, vinyl chloride, vinylidene chloride, acrylamide, methacrylamide and vinyl acetate;

b) 0.5 to 15 percent by weight, based on the components (a), (b) and (c), of at least one N-substituted maleimide compound or a mixture of at least one N-substituted maleimide compound and at least one ethylenically unsaturated compound; and

c) 0.01 to 5 percent by weight, based on the components (a), (b) and (c), of a photopolymerization initiator.

2. A composition according to Claim 1, which further comprises a thermal polymerization inhibitor and/or a plasticizer.

3. A composition according to Claim 1 or 2, wherein the or each N-substituted maleimide compound is a maleimide compound having at the N-position thereof a substituent selected from a straight chain alkyl group having 1 to 22 carbon atoms, a branched alkyl group having 1 to 22 carbon atoms, a cyclic alkyl group having 1 to 22 carbon atoms, an unsubstituted phenyl group, an unsubstituted naphthyl group, a phenyl group substituted with a halogen atom or a straight chain or branched alkyl group having 1 to 6 carbon atoms, a naphthyl group substituted with a halogen atom or a straight chain or branched alkyl group having 1 to 6 carbon atoms, and an aralkyl group of which the alkyl moiety has 1 to 6 carbon atoms and is substituted with at least one phenyl group.

4. A composition according to Claim 1 or 2, wherein the or each N-substituted maleimide compound is a maleimide compound having two maleimide groups bonded, at the respective N-position thereof, to a divalent hydrocarbon residue selected from an alkylene group having 1 to 12 carbon atoms, a phenylene group, a biphenylene group, a 1,6-hexamethylenebiphenylene group, a methylenbiphenylene group and a 2,2-diphenylenepropane group.

5. A composition according to Claim 3, wherein the or each N-substituted maleimide compound has at the N-position thereof a substituent selected from a straight chain alkyl group having 6 to 22 carbon atoms, a cyclic alkyl group having 6 to 22 carbon atoms and a branched alkyl group having 6 to 22 carbon atoms.

6. A composition according to any preceding claim, wherein the N-substituted maleimide compound content of the composition is the range of 0.5 to 10 percent by weight.

7. A composition according to any preceding claim, wherein the or each conjugated diene compound is selected from butadiene, isoprene, chloroprene and dimethylbutadiene.

8. A composition according to any preceding claim, wherein the $\alpha,\beta$-ethylenically unsaturated carboxylic acid is acrylic acid, methacrylic acid, or a mixture thereof.

9. A composition according to any preceding claim, wherein the or each monoene compound is selected from styrene, α-methylstyrene, vinyltoluene and p-methoxystyrene.

10. A composition according to Claim 9, wherein the monoene compound is styrene.

11. A composition according to any preceding claim, wherein the or each ethylenically unsaturated compound is selected from diacrylates and dimethacrylated of ethylene glycol, diethylene glycol, propylene glycol, dipropylene glyco!, polyethylene glycol, polypropylene glycol and butylene glycol, trimethylolpropane triacrylate, trimethylolpropane trimethacrylate, pentaerythritol tetraacrylate, pentaerythritol tetramethacrylate, N,N'-hexamethylene bisacrylamide, N,N'-hexamethylene bismethacrylamide, diacetone acrylamide, diacetone methacrylamide, styrene, vinyltoluene, divinylbenzene, diallyl phthalate, triallyl cyanurate, diethyl fumarate, dibutyl fumarate, dioctyl fumarate, distearyl fumarate, butyl octyl fumarate, diphenyl fumarate, dibenzyl fumarate, dibutyl maleate, dioctyl maleate, bis(3-phenyl-propyl)fumarate, dilauryl fumarate and di(biphenyl)fumarate.

## Patentansprüche

1. Photopolymerisierbare Zusammensetzung, die ein Copolymer mit einer Vielzahl von nicht endständigen ethylenischen Gruppen, ein monomeres Vernetzungsmittel und einen Photoinitiator enthält, dadurch gekennzeichnet, daß sie enthält:

a) 80 bis 99,49 Gewichtsprozent, bezogen auf die Komponenten (a), (b) und (c), eines Copolymeren mit einem Zahlenmittelmolekulargewicht von 20 000 bis 70 000, wobei das Copolymer ein solches ist, das durch Copolymerisieren von

i) 50 bis 95 Gewichtsprozent, bezogen auf die Komponenten (i), (ii) und (iii), mindestens einer konjugierten Dienverbindung,

ii) 5 bis 40 Gewichtsprozent, bezogen auf die Komponenten (i), (ii) und (iii), mindestens einer α,β-ethylenisch ungesättigten Carbonsäure und

iii) 0 bis 30 Gewichtsprozent, bezogen auf die Komponenten (i), (ii) und (iii), mindestens einer Monoenverbindung, ausgewählt aus der aus Styrol, α-Methylstyrol, Vinyltoluol, p-Methoxystyrol, Acrylnitril, Methacrylnitril, Vinylchlorid, Vinylidenchlorid, Acrylamid, Methacrylamid und Vinylacetat bestehenden Gruppe, erhalten ist,

(b) 0,5 bis 15 Gewichtsprozent, bezogen auf die Komponenten (a), (b) und (c), mindestens einer N-substituierten Maleinimid-Verbindung oder eines Gemisches aus mindestens einer N-substituierten Maleinimidverbindung und mindestens einer ethylenisch ungesättigten Verbindung; und

(c) 0,01 bis 5 Gewichtsprozent, bezogen auf die Komponenten (a), (b) und (c),eines Photopolymerisationsinitiators.

2. Zusammensetzung nach Anspruch 1, die weiterhin einen Wärmepolymerisationsinhibitor und/oder einen Weichmacher enthält.

3. Zusammensetzung nach Anspruch 1 oder 2, wobei die oder jede N-substituierte Maleinimidverbindung eine Maleinimidverbindung ist, die in der N-Stellung einen Substituenten hat, der ausgewählt ist unter einer geradkettigen Alkylgruppe mit 1 bis 22 Kohlenstoffatomen, einer verzweigten Alkylgruppe mit 1 bis 22 Kohlenstoffatomen, einer cyclischen Alkylgruppe mit 1 bis 22 Kohlenstoffatomen, einer unsubstituierten Phenylgruppe, einer unsubstituierten Naphthylgruppe, einer mit einem Halogenatom oder einer geradkettigen oder verzweigten Alkylgruppe mit 1 bis 6 Kohlenstoffatomen substituierten Phenylgruppe, einer mit einem Halogenatom oder einer geradkettigen oder verzweigten Alkylgruppe mit 1 bis 6 Kohlenstoffatomen substituierten Naphthylgruppe und einer Aralkylgruppe, bei der der Alkylrest 1 bis 6 Kohlenstoffatome hat und die mit mindestens einer Phenylgruppe substituiert ist.

4. Zusammensetzung nach Anspruch 1 oder 2, wobei die oder jede N-substituierte Maleinimidverbindung eine Maleinimidverbindung ist, die zwei Maleinimidgruppen aufweist, die an ihrer jeweiligen N-Stellung an einen zweiwertigen Kohlenwasserstoffrest, ausgewählt unter einer Alkylengruppe mit 1 bis 12 Kohlenstoffatomen, einer Phenylengruppe, einer Biphenylengruppe, einer 1,6-Hexamethylenbiphenylengruppe, einer Methylenbiphenylengruppe und einer 2,2-Diphenylenpropangruppe, gebunden sind.

5. Zusammensetzung nach Anspruch 3, wobei die oder jede N-substituierte Maleinimidverbindung an ihrer N-Stellung einen Substituenten, ausgewählt unter einer geradkettigen Alkylgruppe mit 6 bis 22 Kohlenstoffatomen, einer cyclischen Alkylgruppe mit 6 bis 22 Kohlenstoffatomen und einer verzweigten Alkylgruppe mit 6 bis 22 Kohlenstoffatomen, aufweist.

6. Zusammensetzung nach einem der vorhergehenden Ansprüche, wobei der Gehalt der Zusammensetzung an N-substituierter Maleinimidverbindung in dem Bereich von 0,5 bis 10 Gewichtsprozent liegt.

7. Zusammensetzung nach einem der vorhergehenden Ansprüche, wobei die oder jede konjugierte Dienverbindung unter Butadien, Isopren, Chloropren und Dimethylbutadien ausgewählt ist.

8. Zusammensetzung nach einem der vorhergehenden Ansprüche, wobei die α,β-ethylenisch ungesättigte Carbonsäure Acrylsäure, Methacrylsäure oder ein Gemisch daraus ist.

9. Zusammensetzung nach einem der vorhergehenden Anspüche, wobei die oder jede Monoenverbindung unter Styrol, α-Methylstyrol, Vinyltoluol und p-Methoxystyrol ausgewählt ist.

10. Zusammensetzung nach Anspruch 9, wobei die Monoenverbindung Styrol ist.

11. Zusammensetzung nach einem der vorhergehenden Ansprüche, wobei die oder jede ethylenisch ungesättigte Verbindung unter Diacrylaten und Dimethacrylaten von Ethylenglykol, Diethylenglykol, Propylenglykol, Dipropylenglykol, Polyethylenglykol, Polypropylenglykol und Butylenglykol, Trimethylolpropantriacrylat, Trimethylolpropantrimethacrylat, Pentaerythrittetraacrylat, Pentaerythrittetramethacrylat, N,N′-Hexamethylenbisacrylamid, N,N′-Hexamethylenbismethacrylamid, Diacetonacrylamid, Diacetonmethacrylamid, Styrol, Vinyltoluol, Divinylbenzol, Diallylphthalat, Triallylcyanurat, Diethylfumarat, Dibutylfumarat, Dioctylfumarat, Distearylfumarat, Butyloctylfumarat, Diphenylfumarat, Dibenzylfumarat, Dibutylmaleat, Dioctylmaleat, Bis(3-phenylpropyl)fumarat, Dilaurylfumarat und Di(biphenyl) fumarat ausgewählt ist.

## Revendications

1. Composition photopolymérisable comprenant un copolymère ayant plusieurs groupes éthyléniques non terminaux, un agent réticulant monomère et un photoinitiateur, caractérisé en ce qu'elle comprend :
   (a) de 80 à 99,49 % en poids, par rapport aux constituants (a), (b) et (c), d'un copolymère ayant une masse moléculaire moyenne en nombre de 20.000 à 70.000, ce copolymère étant obtenu en copolymèrisant :
      (i) de 50 à 95 % en poids, par rapport aux constituants (i), (ii) et (iii), d'au moins un diène conjugué,
      (ii) de 5 à 40 % en poids, par rapport aux constituants (i), (ii) et (iii), d'au moins un acide carboxylique à insaturation a, b-éthylénique, et
      (iii) de 0 à 30 % en poids, par rapport aux constituants (i), (ii) et (iii), d'au moins un monoène, choisi parmi le styrène, l'améthylstyrène le vinyl-toluène, le p-méthoxystyrène, l'acrylonitrile, le méthacrylonitrile, le chlorure de vinyle, le chlorure de vinylidène, l'acrylamide, le méthacrylamide et l'acétate de vinyle,
   (b) de 0,5 à 15 % en poids, par rapport aux constituants (a), (b) et (c), d'au moins un maléimide substitué sur l'azote ou d'un mélange d'au moins un maléimide substitué sur et
   (c) de 0,01 à 5 % en poids, par rapport aux constituants (a), (b) et (c), d'un initiateur de photopolymérisation.

2. Composition suivant la revendication 1, qui comprend en outre un inhibiteur de polymérisation thermique et/ou un plastifiant.

3. Composition suivant la revendication 1 ou 2, dans laquelle le maléimide substitué sur l'azote ou chaque maléimide substitué sur l'azote est un maléimide ayant sur l'azote un substituant choisi parmi un groupe alcoyle à chaîne linéaire ayant de 1 à 22 atomes de carbone, un groupe alcoyle ramifié ayant de 1 à 22 atomes de carbone, un groupe cycloalcoyle ayant de 1 à 22 atomes de carbone, un groupe phényle non substitué, un groupe naphtyle non substitué, un groupe phényle substitué par un atome d'halogène ou par un groupe alcoyle à chaîne linéaire ou ramifiée, ayant de 1 à 6 atomes de carbone et un groupe aralcoyle dont le radical alcoyle a de 1 à 6 atomes de carbone et est substitué par au moins un groupe phényle.

4. Composition suivant la revendication 1 ou 2, dans laquelle le maléimide substitué sur l'azote ou chaque maléimide substitué sur l'azote est un maléimide ayant deux groupes maléimide, liés sur leur atome d'azote respectif, à un radical hydrocarboné divalent choisi parmi un groupe alcoylène ayant de 1 à 12 atomes de carbone, un groupe phénylène, un groupe biphénylène, un groupe 1,6-hexaméthylènebiphénylène, un groupe méthylènebiphénylène, et un groupe 2,2-diphénylènepropane.

5. Composition suivant la revendication 3, dans laquelle le maléimide substitué sur l'azote, ou chaque maléimide substitué sur l'azote, a sur l'azote un substituant choisi parmi un groupe alcoyle à chaîne linéaire ayant de 1 à 22 atomes de carbone, un groupe cycloalcoyle ayant de 1 à 22 atomes de carbone et un groupe alcoyle ramifié ayant de 6 à 22 atomes de carbone.

6. Composition suivant l'une des revendications précédentes, dans laquelle la teneur de la composition en le maléimide substitué sur l'azote est comprise entre 0,5 et 10 % en poids.

7. Composition suivant l'une des revendications précédentes, dans laquelle le diène conjugué ou chaque diène conjugué est choisi parmi le butadiène, l'isoprène, le chloroprène et le diméthylbutadiène.

8. Composition suivant l'une des revendications précédentes, dans laquelle l'acide carboxylique à insaturation α,β-éthylénique est l'acide acrylique, l'acide méthacrylique, ou un mélange de ceux-ci.

9. Composition suivant l'une des revendications précédentes, dans laquelle le monoène ou chaque monoène est choisi parmi le styrène, l'α-méthylstyrène, le vinyltoluène et le p-méthoxystyrène.

10. Composition suivant la revendication 9, dans laquelle le monoène est le styrène.

11. Composition suivant l'une des revendications précédentes, dans laquelle le composé à insaturation éthylénique ou chaque composé à insaturation éthylénique est choisi parmi les diacrylates et les diméthacrylates de l'éthylèneglycol, du diéthylèneglycol, du propylèneglycol, du dipropylèneglycol, du polyéthylèneglycol, du polypropylèneglycol et du butylèneglycol, le triacrylate de triméthylolpropane, le trimétracrylate de triméthylolpropane, le tétraacrylate de pentaérythrite, le tétramétracrylate de pentaérythrite, le N, N'-hexaméthylènebisacrylamide, le N, N' hexaméthylènebisméthacrylamide, le diacétoneacrylamide, le diacétoneméthacrylamide, le styrène, le vinyltoluène, le divinylbenzène, phtalate de diallyle, le cyanurate de triallyle, le fumarate de diéthyle, le fumarate de dibutyle, le fumarate de dioctyle, le fumarate de distéaryle, le fumarate de butyle et d'octyle, le fumarate de diphényle, le fumarate de dibenzyle, le maléate de dibutyle, le maléate de dioctyle, le fumarate de bis (3-phénylpropyle), le fumarate de dilauryle et le fumarate de di(biphényle).